Europäisches Patentamt

European Patent Office

Office européen des brevets

(11) Veröffentlichungsnummer: **0 284 862**

**A1**

## (12) EUROPÄISCHE PATENTANMELDUNG

(21) Anmeldenummer: 88103942.4

(22) Anmeldetag: 12.03.88

(51) Int. Cl.4 **G01R 31/28** .

(30) Priorität: 18.03.87 DE 3708787

(43) Veröffentlichungstag der Anmeldung:
05.10.88 Patentblatt 88/40

(84) Benannte Vertragsstaaten:
AT BE CH DE ES FR GB GR IT LI LU NL SE

(71) Anmelder: **Standard Elektrik Lorenz Aktiengesellschaft**
**Lorenzstrasse 10**
**D-7000 Stuttgart 40(DE)**

(84) DE

(71) Anmelder: **Alcatel N.V.**
**Strawinskylaan 537 (World Trade Center)**
**NL-1077 XX Amsterdam(NL)**

(84) BE CH ES FR GB GR IT LI LU NL SE AT

(72) Erfinder: **Gündner, Hans-Martin, Dr.**
**Wartbergweg 1**
**D-7142 Marbach(DE)**

(74) Vertreter: **Pechhold, Eberhard, Dipl.-Phys. et al**
**Standard Elektrik Lorenz AG Patent- und Lizenzwesen Postfach 30 09 29**
**D-7000 Stuttgart 30(DE)**

(54) Integrierte Schaltung sowie Verfahren und Einrichtung zu ihrer Prüfung.

(57) Es wird ein Verfahren zur On-Wafer-Prüfung sehr schneller integrierter Schaltungen, eine zur Durchführung des Verfahrens ausgelegte Schaltung und eine Einrichtung zur Durchführung des Verfahrens angegeben. Bei diesem Verfahren wird die zu prüfende Schaltung in einer Vakuumkammer (10) an bestimmten Punkten optisch stimuliert und das Potential anderer Schaltungspunkte mittels einer Elektronensonde (7) abgetastet. Um die Schaltung optisch stimulieren zu können, werden bereits bei Auslegung der Schaltung an einer oder mehreren zur Eingabe von Prüfsignalen geeigneten Stellen fotoempfindliche Bauelemente vorgesehen, die zur On-Wafer-Prüfung z.B. mittels eines Lasers (1) bestrahlt werden und ein dem Laserlicht entsprechend moduliertes elektrisches Prüfsignal an die Schaltung abgeben.

Fig. 2

## Integrierte Schaltung sowie Verfahren und Einrichtung zu ihrer Prüfung

Die Erfindung betrifft eine zur Anwendung eines optoelektrisch arbeitenden Prüfverfahrens geeignete integrierte Schaltung sowie das Prüfverfahren selbst und eine Einrichtung zu dessen Durchführung.

Bei der Produktion von integrierten Schaltungen findet, bevor die Schaltungen einzeln in Gehäuse verpackt werden, ein sogenannter "On-Wafer-Test" statt, bei dem die einzelnen Schaltungen auf der noch unzerteilten Trägerscheibe (Wafer) auf einwandfreie Funktion geprüft werden und durch den entschieden wird, welche Schaltungen der sehr aufwendigen Weiterverarbeitung zugeführt werden. Die Ausbeute an guten Schaltungen auf einem Wafer liegt heute noch deutlich unter 50 %.

Für Schaltungen mit Arbeitsfrequenzen bis zu einigen Megahertz können Funktionstests nach Kontaktieren der Schaltungen mit Prüfspitzen (Nadeladaptern) genügend genau durchgeführt werden. Viele Schaltungen arbeiten heute jedoch mit sehr viel höheren Frequenzen. Bei solchen Schaltungen ist das Testen mit Hilfe von Nadeladaptern wegen deren unzureichender Hochfrequenzeigenschaften nicht bei ihrer Betriebsfrequenz anwendbar und es kann nur eine quasistatische Funktionsprüfung durchgeführt werden. Eine weitere Prüfung im hochfrequenten Bereich, bei der gegebenenfalls weitere Schaltungen als nicht funktionsfähig ausgeschieden werden, muß später an den hochwertigen, fertig verpackten Schaltungen durchgeführt werden.

Außer den mit Prüfspitzen arbeitenden Verfahren sind kontaktlos arbeitende Verfahren bekannt. Diese werden bei Schaltungen mit einem Rastermaß unterhalb 200 um angewandt, zu deren Kontaktierung selbst feinste Nadeladapter zu grob sind.

Kontaktlos arbeitende Prüfverfahren verwenden Elektronensonden, die das Potential einzelner Schaltungsteile abtasten (Potentialkontrastverfahren). Um Potentialunterschiede in den zu prüfenden Schaltungen zu erzeugen, werden diese vor der Abtastung durch einen oder mehrere weitere Elektronenstrahlen an verschiedenen Punkten aufgeladen oder selektiv entladen. Bei einem in der EP 0104577 B1 beschriebenen Verfahren wird zur Aufladung und Abtastung derselbe Elektronenstrahl (Korpuskularstrahl) verwendet. Die Energie der Elektronen wird hier zur Abtastung auf einen gegenüber dem zur Aufladung verwendeten Wert niedrigeren Wert eingestellt.

Die bekannten kontaktlos arbeitenden Prüfverfahren können infolge der langsam ablaufenden Lade- und Entladevorgänge nur für statische und quasistatische Prüfungen, z.B. die Prüfung einer Verbindung auf Unterbrechung oder die Prüfung auf mögliche Kurzschlüsse zwischen verschiedenen Schaltungsteilen, benutzt werden. Zur Prüfung von schnell ablaufenden Vorgängen sind sie unbrauchbar.

Aufgabe der Erfindung ist deshalb, eine integrierte Schaltung anzugeben, die die Anwendung eines Prüfverfahrens gestattet, das es ermöglicht, sowohl dann, wenn Schaltvorgänge mit sehr hoher Frequenz ablaufen als auch dann, wenn aufgrund eines niedrigen Rastermaßes nicht mehr mit Nadeladaptern kontaktiert werden kann, alle wichtigen elektrischen Funktionen im On-Wafer-Test zu prüfen und damit fehlerhafte Schaltungsexemplare, bevor sie in ihr Gehäuse verpackt werden, auszusondern.

Die Schaltung, die die Aufgabe der Erfindung löst, ist im kennzeichnenden Teil des Patentanspruchs 1 angegeben. Das Vorhandensein von fotoempfindlichen Bauelementen an den Stellen, an denen eine Eingabe von Prüfsignalen in die Schaltung erfolgen soll, macht es möglich, eine Prüfsignaleingabe über Prüfspitzen durch eine optische Eingabe von Prüfsignalen zu ersetzen.

Die optische Stimulation bestimmter Schaltungspunkte einer integrierten Schaltung ist dabei zur Herstellung optischer Verbindungen innerhalb einer integrierten Schaltung und zur laufzeitunabhängigen Taktversorgung einer integrierten Schaltung aus einem Aufsatz von J.W.Goodman et al. in Proc. of the IEEE, Vol. 72, No. 7, July 1984, S. 850 (hier insbesondere S. 858 ff.) bekannt.

Die Ausstattung einer integrierten Schaltung mit fotoempfindlichen Bauelementen erfordert nur einen geringen Aufwand. Da die optisch aktiven Bauelemente sehr wenig Platz benötigen, lassen sie sich innerhalb der Schaltung gut unterbringen. Oft kann der ungenutzte Platz zwischen den Bondflächen am Schaltungsrand zur Unterbringung genutzt werden.

Das Vorhandensein fotoempfindlicher Bauelemente an den mit Prüfsignalen zu stimulierenden Stellen einer integrierten Schaltung ist Voraussetzung für die Anwendung des im Anspruch 2 beschriebenen On-Wafer-Prüfverfahrens, welches neben der kontaktfreien optischen Eingabe der Prüfsignale auch eine kontaktfreie Abtastung von Meßpunkten vorsieht, an denen von den Prüfsignalen ausgelöste Reaktionen der Schaltung, die Aussagen über deren Funktionsfähigkeit gestatten, erfaßt werden.

Zur Bestrahlung der fotoempfindlichen Bauelemente wird gemäß Anspruch 3 zweckmäßig Laserlicht verwendet, das sehr intensiv ist und sich gut auf geringste Strahldurchmesser (einige um) fokussieren läßt. Laserlicht läßt sich auch gut modulieren. Die Zeitauflösung beträgt bei Verwendung von Halbleiter-Laserdioden 0,1 ns, so daß auch Prüfsignale, die mit Frequenzen bis in den GHz-Bereich hinein moduliert sind, Anwendung finden können.

Eine Ausgestaltung des Verfahrens nach der Erfindung sieht die Verwendung von GaAlAs-Laserdioden und Silizium-Fotodioden vor. Diese Bauelementtypen sind hinsichtlich ihres Frequenzbereiches besonders gut aufeinander abgestimmt, so daß die Umsetzung der Strahlung in elektrische Signale mit hohem Wirkungsgrad erfolgt.

Die Ansprüche 6 bis 9 betreffen Einrichtungen zur Durchführung des in den Ansprüchen 2 bis 5 beschriebenen Verfahrens. Während die Ausgestaltung gemäß Anspruch 6 eine Neuausrichtung der Laserstrahlen und des Elektronenstrahls nach jedem Prüflingswechsel erfordert, beschreibt Anspruch 7 eine Prüfeinrichtung, bei der die Ausrichtung und Fokussierung der Laserstrahlen mittels Hologrammen geschieht. Die Verwendung von Hologrammen gemäß Anspruch 8 hat den Vorteil, daß Laser und Schaltungsträger (Wafer) bei Prüflingswechsel fest eingestellt bleiben können. Lediglich der Hologrammträger mit den Hologrammen wird ausgewechselt. Hierdurch werden komplizierte mechanische Einrichtungen zur Feineinstellung der Laser eingespart und die Prüfzeit verkürzt.

Eine weitere Ausgestaltung der erfindungsgemäßen Einrichtung, die in Anspruch 9 angegeben ist, ermöglicht die Reduzierung der Zahl der Laser, wenn an mehreren Schaltungspunkten fotoempfindliche Bauelemente synchron zu stimulieren sind.

Anhand dreier Figuren soll nun ein Ausführungsbeispiel der integriererten Schaltung nach der Erfindung, das erfindungsgemäße Prüfverfahren sowie hierzu verwendbare Einrichtungen ausführlich beschrieben werden.

Fig. 1 zeigt ein einfaches Beispiel für die Anordnung eines fotoempfindlichen Bauelements für Prüfzwecke in einer integrierbaren Schaltung;

Fig. 2 zeigt eine für die Prüfung der mit fotoempfindlichen Bauelementen für Prüfzwecke ausgestatteten Schaltungen geeignete Einrichtung;

Fig. 3 zeigt schematisch eine Möglichkeit der Lichtfokussierung zur Stimulierung der fotoempfindlichen Bauelemente.

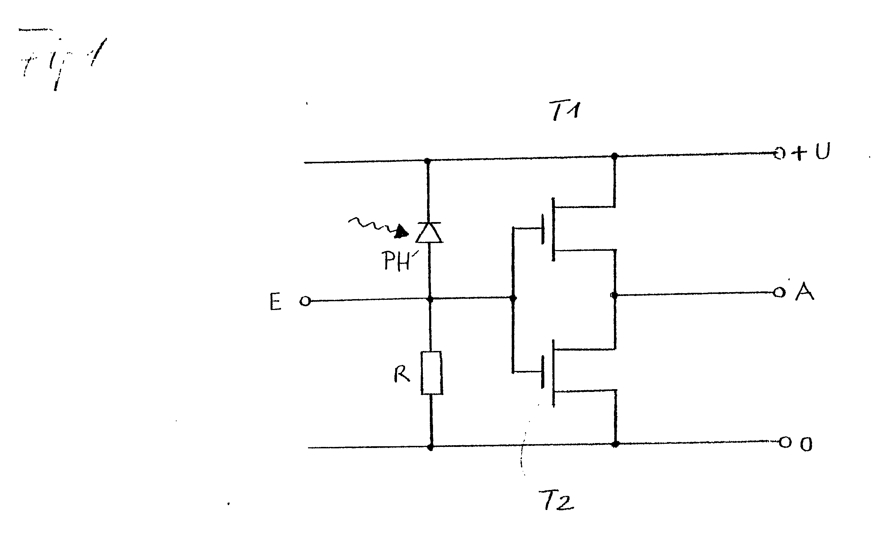

In Fig. 1 ist ein bekannter CMOS-Inverter, bestehend aus zwei CMOS-Feldeffekttransistoren T1 und T2 dargestellt. Er besitzt einen Eingang E und einen Ausgang A und wird mit einer zwischen Anschlüssen +U und 0 anstehenden Spannung versorgt. Zwischen Eingang E und der negativen Seite (Anschluß 0) der Versorgungsspannung ist ein Widerstand R angeordnet, der dafür sorgt, daß der Eingang, solange über den Eingangsanschluß E kein positives Potential zugeführt wird, auf niedrigem Potential liegt. Damit liegt der Ausgang A auf hohem Potential, da der Transistor T1 leitend gesteuert ist und der Transistor T2 sperrt. Der CMOS-Inverter enthält nun zusätzlich eine Fotodiode PH, die in Sperrichtung zwischen den Eingang E und den positiven Anschluß +U der Versorgungsspannung geschaltet ist. Um diese Fotodiode wurde der bekannte CMOS-Inverter erweitert, um eine Prüfung seiner Funktion im unverpackten Zustand bei kontaktfreier Prüfsignaleingabe durchführen zu können. Hierzu wird die Fotodiode, z.B. mittels eines Halbleiterlasers, stimuliert, d.h. in diesem Falle mit intensivem Licht bestrahlt. Sie wird dadurch in Sperrichtung leitend und legt den Eingang E auf hohes Potential. Der Ausgang des Inverters muß nun, wenn der Inverter einwandfrei arbeitet, niedriges Potential führen, was durch Abtastung des Ausgangs A mittels einer Elektronensonde in bekannter Weise festgestellt werden kann.

Komplizierte integrierte Schaltungen, die zur Prüfung anstelle eines zu stimulierenden Punktes ein eine ganze Anzahl von Stimulationspunkten umfassendes Prüfmuster benötigen, müssen an allen zu stimulierenden Punkten mit Fotodioden-Strukturen versehen sein. Der hierfür notwendige Flächenbedarf ist jedoch gering, da z.B. bei Verwendung von Laserdioden zur Bestrahlung der Fotodioden eine Fokussierung der Lichtflecke auf einige um Durchmesser möglich ist. In vielen Fällen wird man den ungenutzten Platz zwischen Bondflächen der integrierten Schaltungen nutzen können. In manchen Fällen lassen sich auch ohnehin notwendige Schutzdioden an den Schaltungseingängen zugleich als Fotodioden nutzen. Als Halbleiterlaser eignen sich z.B. besonders GaAlAs-Dioden, deren Strahlung in Silizium-Photodioden mit hohem Wirkungsgrad in ein elektrisches Signal umgesetzt wird.

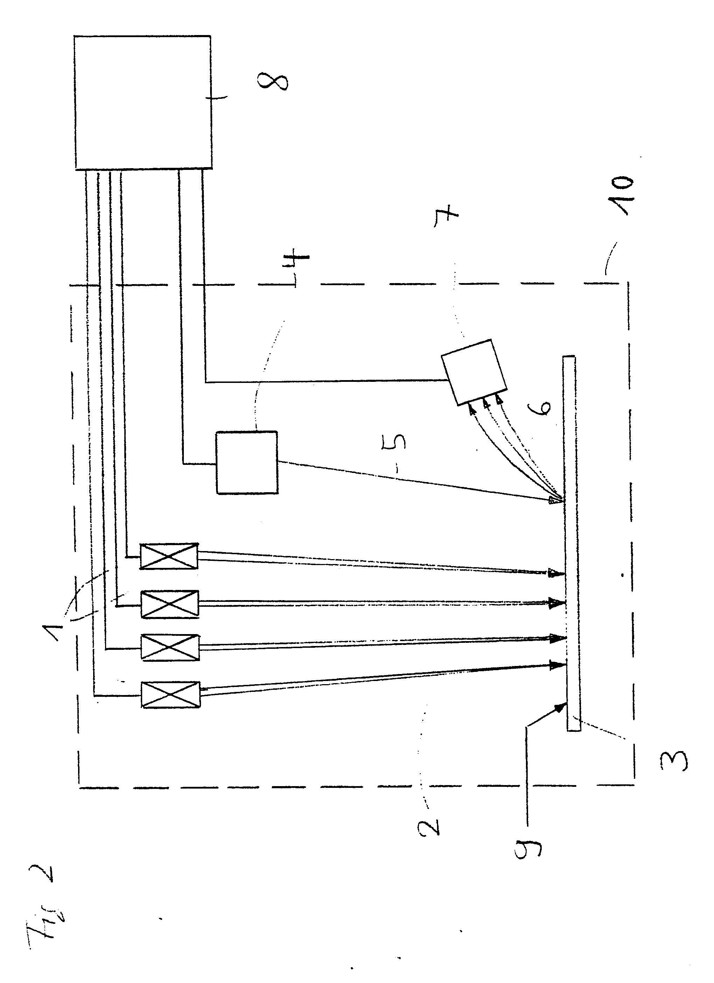

In Fig. 2 ist schematisch eine Prüfeinrichtung dargestellt, die für die On-Wafer-Prüfung mit fotoempfindlichen Bauelementen ausgestatteter integrierter Schaltungen verwendet werden kann.

Ein Wafer 3, der eine große Zahl zu prüfender, mit fotoempfindlichen Bauelementen versehener integrierter Schaltungen trägt, befindet sich in einer Vakuumkammer 10 eines Rasterelektronenmikroskops. Je ein Halbleiterlaser 1 für jedes notwendige Prüfsignal einer zu prüfenden integrierten Schaltung wird von einer Steuerelektronik 8 gemäß einem Prüfprogramm moduliert. Durch geeignete mechanische und/oder optische Mittel werden die Laserstrahlen 2 auf die fotempfindlichen Bauelemente (z.B. Fotodioden) der zu prüfenden Schaltung fokussiert. Ein Elektronenstrahl 5, dessen Quelle 4 ebenfalls von der Steuerelektronik 8 angesteuert wird, tastet ein Reihe von im Prüfprogramm vorgegebenen Meßpunkten ab. Dabei werden an den Meßpunkten entstehende Sekundärelektronen 6 in einem Detektor 7 aufgefangen und analysiert. Die Stromversorgung der zu prüfenden Schaltung wird dabei über Spitzenkontakte 9 sichergestellt, die für alle auf dem Wafer befindlichen Schaltungen gemeinsam, einmal vorhanden sind. Die Weiterschaltung von einer Schaltung zur nächsten kann durch Verschieben des Wafers mittels mechanischer Steppervorrichtungen oder durch Wechsel der Einstellung der Licht-und Elektronenstrahlen erfolgen. Letzteres erfordert jedoch komplizierte und zeitraubende Justierungsmaßnahmen und einen entsprechend hohen apparativen Aufwand.

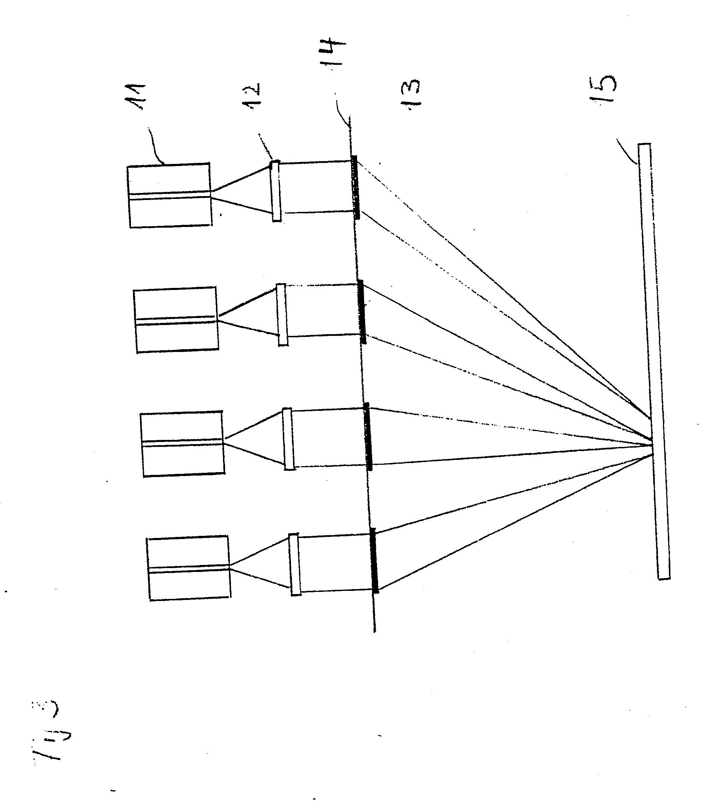

In Fig. 3 ist deshalb das Prinzip eines holographischen Verfahrens dargestellt, welches eine Neupositionierung der Laserstrahlen gestattet, ohne daß Wafer oder Laser hierzu bewegt werden müssen. Einer der Zahl der vorhandenen fotoempfindlichen Bauelemente entsprechenden Anzahl von Laserdioden 11 sind Linsensysteme 12 zugeordnet, die die zunächst kegelig aufgeweiteten Laserstrahlen parallelisieren. Jedes parallele Strahlenbündel ist auf ein Hologramm 13 gerichtet, das auf einem Träger 14 befestigt ist und die Information über die Lage des zu beleuchtenden Punktes auf dem Wafer 15 enthält. Der Lichtstrahl wird damit nahezu vollständig auf das zu stimulierende fotoempfindliche Bauelement fokussiert. Durch einfaches Auswechseln der Hologramme durch Austausch des gesamten Trägers 14 kann hier in kurzer Zeit eine neue Lichtpunktanordnung erzeugt werden, ohne daß die Lage des Wafers oder der Laserdioden verändert werden muß. Letzteres erleichtert auch ganz entscheidend die elektrische Ansteuerung der Laser zur Erzeugung der Prüfmuster.

**Ansprüche**

1. Integrierte Schaltung,
**dadurch gekennzeichnet**, daß sie mindestens ein fotoempfindliches optoelektronisches Bauelement (PH) an einer zur Eingabe eines Prüfsignals geeigneten Stelle enthält, das bestimmungsgemäß dazu dient, im unverpackten Zustand der Schaltung bei Bestrahlung mit Licht ein Prüfsignal an die Schaltung abzugeben.

2. Verfahren zur Prüfung von unverpackten, gemäß Patentanspruch 1 ausgebildeten integrierten Schaltungen, dadurch gekennzeichnet, daß die integrierten Schaltungen in eine Vakuumkammer (10) gebracht und an Stellen, an denen sich zur Abgabe von Prüfsignalen vorgesehene fotoempfindliche Bauelemente befinden, mit Licht bestrahlt werden und daß gleichzeitig eine Abtastung der Potentiale anderer Schaltungspunkte mittels einer Elektronensonde erfolgt.

3. Verfahren nach Anspruch 2, dadurch gekennzeichnet, daß zur Bestrahlung der fotoempfindlichen Bauelemente Laserlicht verwendet wird.

4. Verfahren nach Anspruch 3, dadurch gekennzeichnet, daß das Laserlicht entsprechend den erforderlichen Prüfsignalen moduliert ist.

5. Verfahren nach Anspruch 2, 3 oder 4, dadurch gekennzeichnet, daß als fotoempfindliche Bauelemente Silizium-Photodioden und zur Erzeugung des Laserlichts GaAlAs-Halbleiterlaser verwendet werden.

6. Einrichtung zur Durchführung des Verfahrens nach einem der Ansprüche 2 bis 5, dadurch gekennzeichnet, daß sie aus einer Vakuumkammer (10) zur Aufnahme der zu prüfenden, auf einer unzerteilten Trägerscheibe (3) (Wafer) angeordneten integrierten Schaltungen besteht, die eine der Anzahl der mit Prüfsignalen zu beaufschlagenden Punkten einer Schaltung entsprechende Zahl von Lasern (1), eine Elektronenstrahlquelle (4), einen Sekundärelektronendetektor (7) sowie Einrichtungen zur Fokussierung und Ausrichtung der Laserstrahlen und des Elektronenstrahls und zur Verschiebung der Trägerscheibe (3) enthält, und aus einer Steuer-und Auswerteeinrichtung (8) zur Erzeugung der Steuersignale für die Laser und die Elektronenstrahlquelle und zur Auswertung der Signale des Sekundärelektronendetektors.

7. Einrichtung nach Anspruch 6, dadurch gekennzeichnet, daß zur Ausrichtung und Fokussierung der Laserstrahlen Hologramme (13) benutzt werden, die in den durch Linsensysteme (12) aufgeweiteten und parallelisierten Strahlen der einzelnen Laser (11) angeordnet sind und die Information über die Position und Ausdehnung des vom jeweiligen Laser (11) zu beleuchtenden fotoempfindlichen Bauelements enthalten.

8. Einrichtung nach Anspruch 7, dadurch gekennzeichnet, daß die Hologramme (13) auf einem auswechselbaren Träger (14) angeordnet sind.

9. Einrichtung nach Anspruch 7 oder 8, dadurch gekennzeichnet, daß zur gleichzeitigen Stimulation mehrerer Schaltungspunkte mit demselben Prüfsignal Hologramme vorgesehen sind, die das Licht eines einzigen Lasers auf mehrere fotoempfindliche Bauelemente aufteilen und fokussieren.

H.M.Gündner 6

+U

A

0

T1

T2

PH

R

E

Fig.1

Fig 2

1

2

3

4

5

6

7

8

9

10

0 284 862

H.M.Gündner 6

Fig 3

11

12

14

13

15

0 284 862

H.M.Gündner 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | IEEE JOURNAL OF SOLID-STATE CIRCUITS, Band SC-12, Nr. 3, June 1977, Seiten 247-252; J.G. SMITH et al.: "Laser testing of integrated circuits" * Seite 247, linke Spalte, letzter Absatz - Seite 248, linke Spalte, Absatz 4; Figuren 1,2 * | 1 | G 01 R 31/28 |
| Y | IDEM | 2 | |
| A | IDEM | 3,6 | |
| X | US-A-4 053 833 (MALMBERG et al.) * Zusammenfassung; Spalte 5, Zeilen 24-40; Spalte 11, Zeilen 10-16; Figuren 1,7 * | 1 | |
| A | | 2,4,6 | |
| Y | EP-A-0 209 236 (TEXAS INSTRUMENTS) * Zusammenfassung; Figur 1 * | 2,6 | |
| Y | MICROELECTRONIC ENGINEERING, Band 5, Nr. 1-4, Dezember 1986, Seiten 547-553, Elsevier Science Publishers B.V.; H.K. SEITZ et al.: "Energy and time-resolved photoemission in a promising new approach for contactless integrated-circuit testing" * Seite 547, Zeilen 20-34; Figur 8 * | 6 | RECHERCHIERTE SACHGEBIETE (Int. Cl.4) G 01 R |
| A | IDEM --- -/- | 2,4 | |

Der vorliegende Recherchenbericht wurde für alle Patentansprüche erstellt

| Recherchenort | Abschlußdatum der Recherche | Prüfer |
|---|---|---|
| DEN HAAG | 23-06-1988 | HARRISON R.J. |

Europäisches Patentamt

# EUROPÄISCHER RECHERCHENBERICHT

Nummer der Anmeldung

EP 88 10 3942

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | PROCEEDINGS OF THE IEEE, Band 72, Nr. 7, July 1984, Seiten 850-866, IEEE; J.W. GOODMAN et al.: "Optical interconnections for VLSI systems" * Seite 856, linke Spalte, Zeilen 52-59; Seite 856, rechte Spalte, Zeilen 19-32; Seite 860, rechte Spalte, Zeilen 8-37 * | 1-9 | |
| | | | **RECHERCHIERTE SACHGEBIETE (Int. Cl.4)** |

Der vorliegende Recherchenbericht wurde für alle Patentansprüche erstellt

| Recherchenort | Abschlußdatum der Recherche | Prüfer |
|---|---|---|
| DEN HAAG | 23-06-1988 | HARRISON R.J. |